(19) **Europäisches Patentamt**

**European Patent Office**

**Office européen des brevets**

(11) **EP 1 061 590 A1**

(12) **EUROPEAN PATENT APPLICATION**
published in accordance with Art. 158(3) EPC

(43) Date of publication:
20.12.2000 Bulletin 2000/51

(51) Int. Cl.⁷: **H01L 33/00**

(21) Application number: **99973592.1**

(86) International application number:
**PCT/JP99/06533**

(22) Date of filing: **24.11.1999**

(87) International publication number:
**WO 00/41249 (13.07.2000 Gazette 2000/28)**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.12.1998 JP 37315398**

(71) Applicant:
**Shin-Etsu Handotai Co., Ltd**
**Tokyo 100-0005 (JP)**

(72) Inventors:
• **SUZUKI, Kingo**
 **Shin-Etsu Handotai Co., Ltd.**
 **Annaka-shi Gunma 379-0196 (JP)**
• **IKEDA, Hitoshi**
 **Shin-Etsu Handotai Co., Ltd.**
 **Annaka-shi Gunma 379-0196 (JP)**

(74) Representative:
**Grünecker, August, Dipl.-Ing.**
**Patentanwälte**
**Grünecker, Kinkeldey, Stockmair & Partner**
**Maximilianstrasse 58**
**80538 München (DE)**

(54) **LIGHT EMITTING DIODE AND ITS MANUFACTURING METHOD**

(57) Provided are a light emitting diode (GaAsP LED) made of a gallium arsenide phosphide GaAsP mixed crystal whose luminous intensity is greatly improved as compared with a conventional one, and a fabrication process therefor. In a light emitting diode comprising a pellet a major front surface of which is made of a GaAsP mixed crystal, the major front surface is a rough surface.

FIG. 1

## Description

Technical Field

The present invention relates to a light emitting diode [hereinafter may be simply referred to as LED (an abbreviation of Light Emitting Diode)] and a fabrication process therefor, and more particularly, to a light emitting diode made of a gallium arsenide phosphide $GaAs_{1-x}P_x$ mixed crystal (hereinafter the light emitting diode and $GaAs_{1-x}P_x$ may be simply referred to as GaAsP LED and GaAsP, respectively) and a fabrication process therefor.

Background Art

A light emitting diode made of a gallium arsenide phosphide $GaAs_{1-x}P_x$ mixed crystal can emit yellow light with a wavelength of 583 nm (x = 0.90), orange light with a wavelength of 626 nm (x = 0.65), red light with a wavelength of 648 nm (x = 0.50) or the like by changing a bandgap width through varying a mixed crystal ratio (x) and has been employed as a light source for a display device and so on.

In general, an LED is required to have high luminous intensity. A light emission efficiency of the LED is determined by an internal quantum efficiency and a light extraction efficiency. Since the internal quantum efficiency is determined by composition of materials of which the LED is made, in order to increase the light emission efficiency, the light extraction efficiency is necessarily increased by suppressing a loss due to optical absorption in the interior of the LED and a loss of light that cannot be extracted to the outside by total reflection at an interface between a light emitting surface and the air

In order to increase the light extraction efficiency, there have been known processes in which a semiconductor wafer having a p-n junction is cut into pellets in a discrete state and surfaces of the pellets are roughened (Japanese Patent Laid-open Publication Nos. 4-354382 and. 6-151959 and others). It is assumed that when the pellet surfaces are roughened, since a probability of total reflection of emitted light at an interface between the light emitting surface and the air decreases, the light extraction efficiency may be increased.

Surface roughening of a pellet can be simply effected by wet etching. For example, in case of a gallium phosphide GaP pellet, surfaces of the pellet can be roughened by etching them with an aqueous solution of hydrochloric acid, that is, HCl (Japanese Patent Laid-open Publication No. 4-354382). Further, in case of surface roughening of an AlGaAs mixed crystal, hydrofluoric acid (Japanese Patent Laid-open Publication No. 6.151959) and a mixed solution of nitric acid: sulfuric acid = 95 : 5 (Japanese Patent Laid-open Publicaton No. 10-200156) are effective.

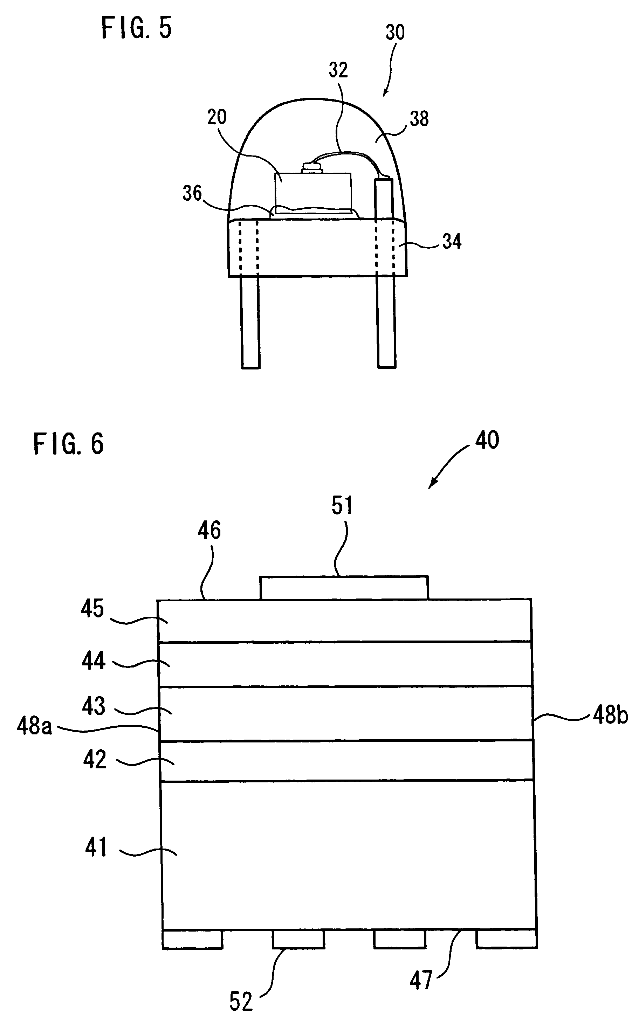

In case of a gallium arsenide phosphide GaAsP mixed crystal, however, there has been no success in developing an etching solution suitable for roughening a major front surface of a pellet thereof and as shown in FIG. 6 the major front surface 46 of the pellet 40 of a GaAsP mixed crystal remains in a mirror state.

The pellet 40 of a GaAsP mixed crystal is produced by for example a process wherein an n-type GaP epitaxial layer 42, an n-type $GaAs_{1-x}P_x$ mixed crystal ratio variable layer 43 in which the mixed crystal ratio varies, a nitrogen doped n-type $GaAs_{1-x}P_x$ mixed crystal ratio constant layers 44 and 45 are sequentially deposited on an n-type GaP single crystal substrate 41; thereafter, zinc Zn is diffused through the surface of the $GaAs_{1-x}P_x$ mixed crystal ratio constant layer 45 to invert a conductivity thereof to p-type and form a p-n junction at the boundary between the mixed crystal ratio constant layers 44 and 45; subsequently, gold alloy is vacuum evaporated on the major front and rear surfaces 46 and 47 to form a p-side electrode 51 and an n-side electrode 52, respectively; and finally the resultant product is cut in the form of chips by dicing.

In FIG. 6, reference numerals 48a and 48b indicate side surfaces of the pellet which are formed as cut faces almost normal to the major front surface 46 when the pellet is fabricated in the form of chips by dicing. The pellet has further two side surfaces in addition to the side surfaces 48a and 48b shown in FIG. 6.

The present inventors have conducted serious studies in order to develop an etching solution for roughening of at least a major front surface of a GaAsP mixed crystal and as a result, made a finding that an aqueous solution including bromine $Br_2$ or iodine $I_2$ is preferable as the etching solution. The present invention has been completed through various experiments using such an etching solution.

It is an object of the present invention to provide a light emitting diode (GaAsP LED) made of a gallium arsenide phosphide GaAsP mixed crystal which has luminous intensity greatly improved as compared with a conventional one, and a fabrication process therefor.

Disclosure of the Invention

In order to solve the above problem, according to the present invention, there is provided a light emitting diode comprising a pellet a major front surface of which is made of a GaAsP mixed crystal, characterized in that the major front surface is a rough surface.

In the case where side surfaces of the pellet are rough surfaces, a higher light extraction efficiency can be achieved. The rough surface is preferably formed with fine projections having a diameter in a range of from 0.3 $\mu$m to 3 $\mu$m.

A fabrication process for a light emitting diode having a pellet a major front surface of which is made of a GaAsP mixed crystal according to the present invention is characterized in that the pellet is treated with an etching solution of an aqueous solution containing $Br_2$ or $I_2$ to form fine projections on at least the major front surface of the pellet.

The etching solution is preferably an aqueous solution further containing nitric acid, hydrofluoric acid and acetic acid in addition to $Br_2$ or $I_2$. The etching solution preferably contains 40 to 80 parts of nitric acid, 40 to 300 parts of hydrofluoric acid and 400 to 2000 parts of acetic acid based on 1 part of $Br_2$ or $I_2$ in a molar ratio.

Brief Description of the Drawings

FIG. 1 is a schematic sectional view showing a major front surface and side surfaces of a pellet for a light emitting diode of the preset invention.

FIG. 2 is a view illustrating angles of light beams getting to a light emitting surface, and light transmission and reflection states, where FIG. 2(A) shows the light transmission state and FIG. 2(B) shows the light reflection state, respectively.

FIG. 3 is a view illustrating angles of light beams getting to a light emitting surface with fine projections, and light transmission and reflection states, wherein FIG. 3(A) shows a case where a diameter of the projection is in a range of from 0.3 $\mu$m to 3 $\mu$m, FIG. 3(B) shows a case where a diameter of the projection is more than 3 $\mu$m and FIG. 3(C) shows a case where a diameter of the projection is less than 0.3 $\mu$m.

FIG. 4 is a flow chart showing procedures of a fabrication process for a light emitting diode of the present invention.

FIG. 5 is a view showing an embodiment of a light emitting diode.

FIG. 6 is a schematic sectional view showing a major front surface and side surfaces of a pellet for a conventional light emitting diode.

Best Mode for Carrying out the Invention

Detailed description will be given of a light emitting diode according to the present invention and of a fabrication process therefor below with reference to the accompanying drawings. It should be understood that embodiments are exemplarily shown and various modifications and. alterations may be carried out without departing from the technical idea of the present invention.

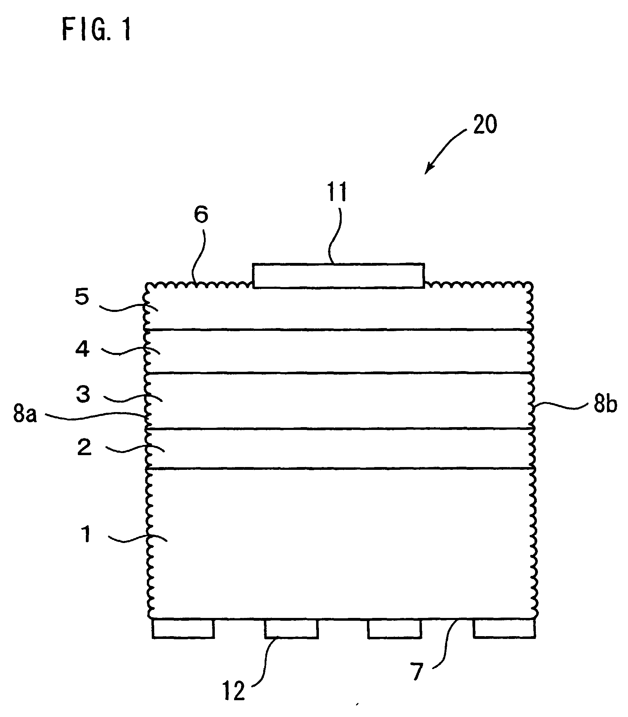

FIG. 1 is a schematic sectional view showing a pellet 20 of a light emitting diode made of gallium arsenide phosphide of the present invention, which may be referred to as GaAsP pellet.

A major front surface 6 made of a GaAsP mixed crystal, as shown in FIG. 1, is changed to a rough surface with fine projections by wet etching in order to improve a light extraction efficiency, and the etching conditions are adjusted so that a diameter of the projection of the rough surface is in a range of from 0.3 $\mu$m to 3 $\mu$m.

Light emitted from the gallium arsenide phosphide GaAsP mixed crystal has wavelengths of around 600 nm ranging from about 580 nm of yellow to about 650 nm of red at a peak wavelength. When the fine projections of the major front surface 6 of the pellet 20 is adjusted so as to be in a range of from 0.3 $\mu$m to 3 $\mu$m, a probability of total reflection of light decreases satisfactorily, thereby improving a light extraction efficiency.

More detailed description will be given of a light extraction efficiency. As described above, in order to obtain a high luminous intensity, it is necessary that the light extraction efficiency is improved by reducing a ratio of emitted light being not extracted to the outside due to total reflection at an interface between the light emitting surface and the air.

Since at a wavelength in the vicinity of 600 nm, the refractive index (n) of GaP is about 3.3 and the refractive index (n) of GaAs is about 3.8, the refractive index (n) of GaAsP, which is a mixed crystal thereof, is in a range of from about 3.3 to about 3.8. In the case where a light beam is transmitted into the air of a refractive index = 1 from a medium having such a high refractive index (n), a critical angle of total reflection $\theta$ is expressed by the following equation:

$$\theta = \sin^{-1}(1/n)$$

Accordingly, in a case of GaAsP having a refractive index (n) = about 3.3 to about 3.8, there is given a critical angle of total reflection $\theta$ = about 15° to about 18°.

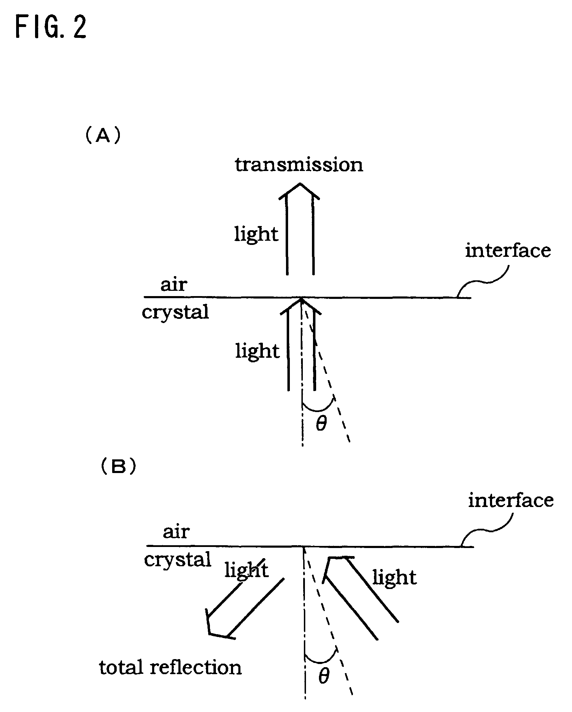

That is, when a light emitting surface is a plane surface as shown in FIG. 2, there is emitted into the air only light getting to the interface at an angle nearly normal thereto and less than the critical angle of total reflection 9 [FIG.

2(A)] , while light getting to the interface at an angle larger than the critical angle of total reflection θ is totally reflected into the interior of the crystal and eventually absorbed therein [FIG. 2(B)].

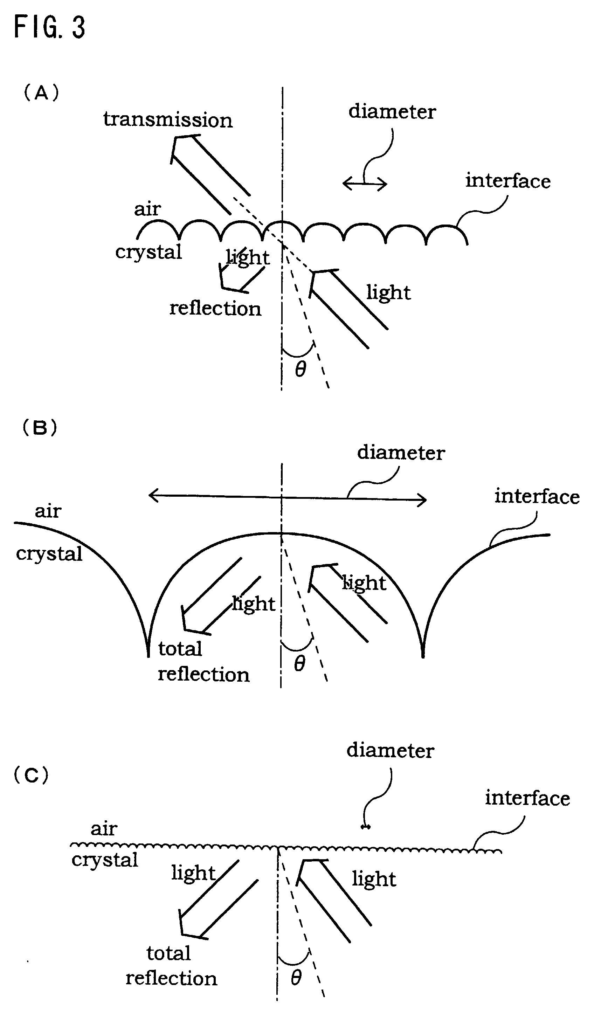

Therefore, the interface between the light emitting surface and the air is changed to a rough surface by wet etching so as to form fine projections, but not a plane surface. When fine projections are formed on the interface, as shown in FIG. 3(A), there exist locally convex surfaces smaller than the critical angle of total reflection θ, so light getting to the interface at an angle larger than the critical angle of total reflection θ can transmit into the air through the convex surfaces [FIG. 3(A)].

In case of a GaAsP mixed crystal, the fine projections may preferably have a diameter in a range of from 0.3 μm to 3 μm [FIG. 3(A)] . If the diameter thereof is larger than 3 μm, the projection surface to the light wavelength is so gentle as to locally work as a mirror surface [FIG. 3(3)]. To the contrary, if the diameter thereof is smaller than 0.3 μm, the projection level to the light wavelength is so small as to become substantially a mirror surface [FIG. 3(C)] . The term "a diameter of a fine projection" used in the present invention means a length from the foot of a projection to the foot of the next projection as shown in FIG. 3. While, in FIG 3, fine projections on the interface are drawn as a series of semi-spherical projections, it may be sufficient for projections of arc-like sectional shapes to be formed densely.

In FIG. 1, when there are formed rough surfaces having fine projections in a range of from 0.3 μm to 3 μm on not only the major front surface 6 but side surfaces 8 of the pellet (8a, 8b and other two sides being further included, not shown in FIG. 1), a light extraction efficiency is further improved.

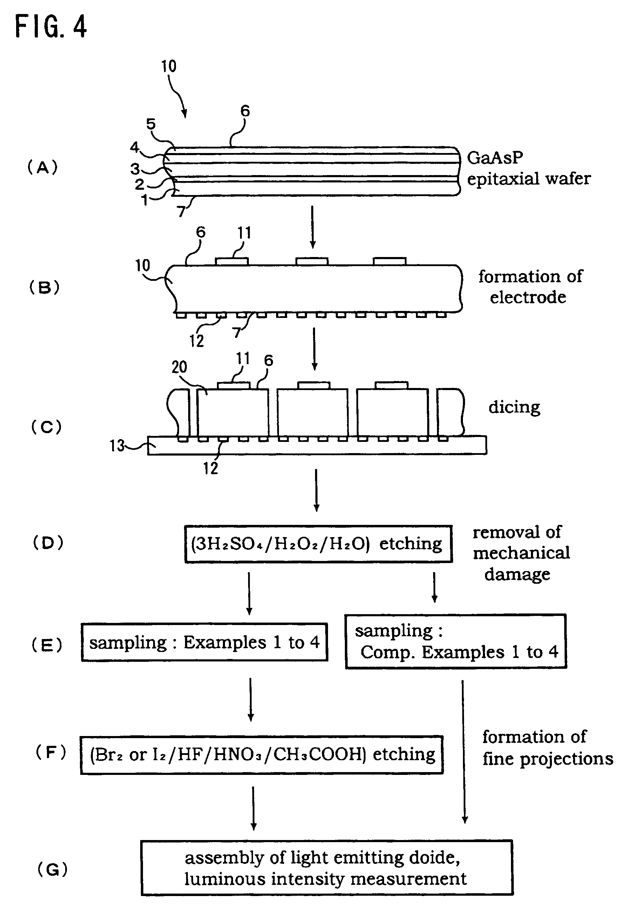

Then, description will be given of a fabrication process for a light emitting diode according to the present invention using FIG. 4.

First, an n-type GaP epitaxial layer 2, an n-type $GaAs_{1-x}P_x$ mixed crystal ratio variable layer 3, in which the mixed crystal ratio varies, a nitrogen doped n-type $GaAs_{1-x}P_x$ mixed crystal ratio constant layers 4 and 5 are sequentially deposited on an n-type GaP single crystal substrate 1 a major front surface of which has a (100) orientation, and thereafter, zinc Zn is diffused through the surface of the $GaAs_{1-x}P_x$ mixed crystal ratio constant layer 5 to invert a conductivity thereof to p-type and obtain a GaAsP epitaxial wafer 10 with a p-n junction at the boundary between the mixed crystal ratio constant layers 4 and 5 [step (A)] .

Subsequently, gold alloy is vacuum evaporated on the major front and rear surfaces 6 and 7 to form a p-side electrode 11 and an n-side electrode 12, respectively [step (B)] . Then, the GaAsP epitaxial wafer 10 is put on a adhesive tape 13 so as to cover the n-side electrode 12 and the GaAsP epitaxial wafer 10 is cut into pellets 20 each of 0.3 mm × 0.3 mm square by dicing [step (C)] .

Further, the cut pellet 20 is subjected to etching by the use of a first etching solution composed of 96 % sulfuric acid $H_2SO_4$ : 32 % hydrogen peroxide $H_2O_3$ : water $H_2O$ = 3 : 1 : 1 in a volume ratio for 2 minutes to remove mechanical damage induced by dicing [step (D)] .

Furthermore, the pellet 20 is subjected to a second etching solution of an aqueous solution containing bromine $Br_2$ or iodine $I_3$ in order to form fine projections in a range of from 0.3 μm to 3 μm on the major front surface 6 and the side surfaces 8a and 8b of the pellet 20 [step (F)] . The aqueous solution containing $Br_2$ or $I_2$ has not been employed conventionally for surface roughening treatment of a GaAsP mixed crystal. In this etching, the major rear surface 7 of the pellet 20 is covered with the adhesive tape 13 to protect the surface from the second etching solution so as not to be roughened. A major rear surface 7 preferably has a mirror surface rather than a rough surface because of increase in a light extraction efficiency due to the fact that light can not escape through the major rear surface 7.

Describing in a more concrete manner, the second etching solution of an aqueous solution containing in addition to $Br_2$ or $I_2$, 40 to 80 parts of nitric acid $HNO_3$, 40 to 300 parts of hydrofluoric acid HF and 400 to 2000 parts of acetic acid $CH_3COOH$ based on 1 part of $Br_2$ or $I_2$ in a molar ratio is prepared and thereafter, the major front surface 6, side surfaces 8a and 8b and so on of the GaAsP pellet 20 are treated with the second etching solution for a predetermined time to form rough surfaces having fine projections in a range of from 0.3 μm to 3 μm. An optimum etching time varies to some extent according to a mixed crystal ratio of GaAsP and composition of the etching solution. Since the second etching solution roughens not only a GaAsP mixed crystal but GaP partly exposed on the side surfaces of the pellet 20 as well, all of the major front surface 6, side surfaces 8a and 8b and so on exposed to the second etching solution are changed to rough surfaces.

Description will be given, taking up further concrete examples, of conditions of etching according to the present invention and luminous intensity of a light emitting diode whose pellet is made of a GaAsP mixed crystal having fine surface projections formed by the etching. The following examples are shown for exemplary purposes and as a matter of course should not be construed as restrictive.

(Example 1)

A GaAsP pellet 20 a major front surface of which has a (100) orientation was etched with a first etching solution composed of 96 % sulfuric acid $H_2SO_4$: 32 % hydrogen peroxide $H_2O_2$: water $H_2O$ = 3 : 1 : 1 in a volume ratio for 2 minutes [FIG. 4(D)] to remove mechanical damage induced by dicing and further etched with a second etching solution of an aqueous solution containing 60 parts of nitric acid, 200 parts of hydrofluoric acid and 800 parts of acetic acid based on 1 part of $I_2$ in a molar ratio at 30°C for 75 seconds to form fine projections in a range of from 0.3 μm to 3 μm on the major front surface 6, side surfaces 8a and 8b and so on of the GaAsP pellet 20 [FIG. 4(F)] .

Successively, as shown in FIG. 5, the GaAsP pellet 20 was fixed on a stem 34 with silver paste 36 and after wire bonding with gold fine wires 32, molded using transparent epoxy resin 38 to fabricate a light emitting diode 30.

Then, there was measured luminous intensity of yellow light with a wavelength of 580 nm by applying a DC current of 20 mA to the fabricated light emitting diode 30 [FIG. 4(G)] . Measurement results of the luminous intensity are shown in Table 1 (A). In comparison with Comparative Example 1 shown next, the luminous intensity is improved by 88 %. The improvement of the luminous intensity means that the light extraction efficiency was improved by roughening of surfaces of the pellet 20.

(Comparative Example 1)

A light emitting diode 30 was fabricated in the same way as Example 1 with the exception that there was not performed etching to form fine projections on the major front surface 6 and side surfaces 8a and 8b of a GaAsP pellet 20. There was measured luminous intensity by applying a DC current of 20 mA to the fabricated light emitting diode 30 and results thereof are shown in Table 1(B).

(Example 2)

A light emitting diode 30 emitting yellow light with a wavelength of 586 nm was fabricated in the way similar to Example 1 and luminous intensity thereof was measured [Table 1(C)] . In comparison with Comparative Example 2 shown next, the luminous intensity was improved by 73 %.

(Comparative Example 2)

A light emitting diode 30 was fabricated in the same way as Example 2 with the exception that there was not performed etching to form fine projections on the major front surface 6, side surfaces 8a and 8b and so on of a GaAsP pellet 20. There was measured luminous intensity by applying a DC current of 20 mA to the fabricated light emitting diode 30 and results thereof are shown in Table 1(D).

(Example 3)

A light emitting diode 30 emitting yellow-brown light with a wavelength of 605 nm was fabricated in the way similar to Example 1 and luminous intensity thereof was measured [Table 1(E)] . In comparison with Comparative Example 3 shown next, the luminous intensity was improved by 73 %.

(Comparative Example 3)

A light emitting diode 30 was fabricated in the same way as Example 3 with the exception that there was not performed etching to form fine projections on the major front surface 6, side surfaces 8a and 8b and so on of a GaAsP pellet 20. There was measured luminous intensity by applying a DC current of 20 mA to the fabricated light emitting diode 30 and results thereof are shown in Table 1(F).

(Example 4)

A light emitting diode 30 emitting orange light with a wavelength of 630 nm was fabricated in the way similar to Example 1 and luminous intensity thereof was measured [Table 1(G)] . In comparison with Comparative Example 4 shown next, the luminous intensity was improved by 51 %.

(Comparative Example 4)

A light emitting diode 30 was fabricated in the same way as Example 4 with the exception that there was not performed etching to form fine projections on the major front surface 6, side surfaces 8a and 8b and so on of a GaAsP pellet 20. There was measured luminous intensity by applying a DC current of 20 mA to the fabricated light emitting diode 30 and results thereof are shown in Table 1(H).

Table 1

|  |  | Emission Wavelength (nm) | Emission Color | Luminous Intensity (mcd) | Improvement of Luminous Intensity(%) |
|---|---|---|---|---|---|
| (A) | Example 1 | 580 | yellow | 5.41 | 88 |
| (B) | Comp. Example 1 | 580 | yellow | 2.88 | |
| (C) | Example 2 | 586 | yellow | 6.68 | 73 |
| (D) | Comp. Example 2 | 586 | yellow | 3.86 | |
| (E) | Example 3 | 605 | yellow-brown | 4.36 | 73 |
| (F) | Comp. Example 3 | 605 | yellow-brown | 2.52 | |
| (G) | Example 4 | 630 | orange | 4.55 | 51 |
| (H) | Comp. Example 4 | 630 | orange | 3.01 | |

While iodine $I_2$ was employed for preparation of the second etching solutions in the present Examples, similar results can be obtained when bromine $Br_2$ is employed in the same composition as in the case of iodine $I_2$.

Furthermore, while light emitting diodes emitting yellow, yellow-brown and orange light are described in the present Examples, similar results can be obtained for a light emitting diode emitting red light. Besides, since in the present Examples the surface roughening treatment was applied after formation of the p-side electrodes 11 on the major front surfaces 6, the surfaces under the p-side electrodes 11 were not changed to rough surfaces, but the entire major front surfaces 6 can naturally be roughened when the surface roughening treatment is applied prior to formation of the p-side electrodes.

Capability of Exploitation in Industry

As described above, according to the present invention, a light extraction efficiency can be improved by forming fine projections on surfaces of a GaAsP pellet through roughening the surfaces and as a result, luminous intensity can be improved by about 50 % to about 90 % as compared with a conventional one. Further, surface roughening of a major front surface of a GaAsP pellet can be achieved by employing an etching solution of an aqueous solution containing $Br_2$ or $I_2$. To be more concrete, fine projections on the major front surface and side surfaces of the GaAsP pellet 20 can be formed by performing surface roughening treatment with an etching solution of an aqueous solution further containing nitric acid, hydrofluoric acid and acetic acid in addition to $Br_2$ or $I_2$.

**Claims**

1. A light emitting diode comprising a pellet a major front surface of which is made of a GaAsP mixed crystal, characterized in that the major front surface is a rough surface.

2. A light emitting diode according to claim 1, characterized in that side surfaces of the pellet are rough surfaces.

3. A light emitting diode according to claim 1 or 2, characterized in that the rough surface is formed with fine projections having a diameter in a range of from 0.3 $\mu$m to 3 $\mu$m.

4. A fabrication process for a light emitting diode having a pellet a major front surface of which is made of a GaAsP mixed crystal, characterized in that the pellet is treated with an etching solution of an aqueous solution containing $Br_2$ or $I_2$ to form fine projections on at least the major front surface of the pellet.

5. A fabrication process for a light emitting diode according to claim 4, characterized in that the etching solution is an aqueous solution further containing nitric acid, hydrofluoric acid and acetic acid.

6. A fabrication process for a light emitting diode according to claim 5, characterized in that the etching solution contains 40 to 80 parts of nitric acid, 40 to 300 parts of hydrofluoric acid and 400 to 2000 parts of acetic acid based on 1 part of $Br_2$ or $I_2$ in a molar ratio.

FIG. 1

# FIG. 2

(A)

transmission

light

interface

air

crystal

light

$\theta$

(B)

interface

air

crystal

light

light

total reflection

$\theta$

# FIG. 3

(A)

(B)

(C)

# FIG. 4

(A) GaAsP epitaxial wafer

(B) formation of electrode

(C) dicing

(D) $(3H_2SO_4/H_2O_2/H_2O)$ etching — removal of mechanical damage

(E) sampling : Examples 1 to 4 | sampling : Comp. Examples 1 to 4

(F) $(Br_2$ or $I_2/HF/HNO_3/CH_3COOH)$ etching — formation of fine projections

(G) assembly of light emitting doide, luminous intensity measurement

FIG. 5

30

32

20

38

36

34

FIG. 6

40

51

46

45

44

43

48a

42

48b

41

52

47

# EP 1 061 590 A1

## INTERNATIONAL SEARCH REPORT

International application No.

PCT/JP99/06533

### A. CLASSIFICATION OF SUBJECT MATTER
Int.Cl$^7$    H01L33/00

According to International Patent Classification (IPC) or to both national classification and IPC

### B. FIELDS SEARCHED

Minimum documentation searched (classification system followed by classification symbols)
Int.Cl$^7$    H01L33/00, H01L21/306

Documentation searched other than minimum documentation to the extent that such documents are included in the fields searched

| | | |
|---|---|---|
| Jitsuyo Shinan Koho | 1965-1996 | Jitsuyo Shinan Toroku Koho 1996-1999 |
| Kokai Jitsuyo Shinan Koho | 1971-1999 | Toroku Jitsuyo Shinan Koho 1994-1999 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP, 4-42582, A (Eastman Kodak Japan K.K.), | 1,3 |
| Y | 13 February, 1992 (13.02.92)    (Family: none) | 2,4-6 |
| | JP, 55-163884, A (Tokyo Shibaura Denki K.K.), 13 February, 1980 (13.02.80)    (Family: none) | |
| X | page 2, upper right column, the last line to page 2 lower | 1 |
| Y | left column, line 2 | 4-6 |
| Y | JP, 10-65211, A (Mitsubishi Chemical Corporation), 06 March, 1998 (06.03.98)    (Family: none) Par. No. [0013] | 1 |
| Y | JP, 4-116162, U (Sanyo Electric Co., Ltd.), 16 October, 1992 (16.10.92)    (Family: none) | 2 |
| Y | JP, 4-250674, A (Nippon Mining Co., Ltd.), 07 September, 1992 (07.09.92)    (Family: none) | 4-6 |
| A | JP, 59-76492, A (Hitachi, Ltd.), 01 May, 1984 (01.05.84)    (Family: none) | 4-6 |
| A | JP, 59-85868, A (Sumitomo Electric Industries, Ltd.), | 4-6 |

☒ Further documents are listed in the continuation of Box C.    ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 17 February, 2000 (17.02.00) | 29 February, 2000 (29.02.00) |

| Name and mailing address of the ISA/ | Authorized officer |
|---|---|
| Japanese Patent Office | |
| Facsimile No. | Telephone No. |

Form PCT/ISA/210 (second sheet) (July 1992)

12

**INTERNATIONAL SEARCH REPORT**

| International application No. |
|---|
| PCT/JP99/06533 |

C (Continuation). DOCUMENTS CONSIDERED TO BE RELEVANT

| Category* | Citation of document, with indication, where appropriate, of the relevant passages | Relevant to claim No. |
|---|---|---|
| | 17 May, 1984 (17.05.84)  (Family: none) | |
| A | JP, 61-77327, A (NEC Corporation), 19 April, 1986 (19.04.86)  (Family: none) | 4-6 |

Form PCT/ISA/210 (continuation of second sheet) (July 1992)